# EUROPEAN PATENT APPLICATION

(11) **EP 4 835 530 A1**
(43) Date of publication of application: **04.11.2026**
(21) Application number: 26172182.3
(22) Date of filing: 14.04.2026
(51) Int. Cl.: G02B 6/44, H05K 7/14

(54) **TRAYS HAVING PULL-OUT MINI-TRAYS WITH ON BOARD OPTICAL MODULES**

(30) Priority: 30.04.2025 US 202519194778
(71) Applicant: Microsoft Technology Licensing, LLC, Redmond, WA 98052 (US)
(72) Inventor: ROYTMAN, Eduard, Redmond, Washington 98052 (US); TRIEU, Dennis, Redmond, Washington 98052 (US); LAVIER, Jack T., Redmond, Washington 98052 (US); CAULFIELD, Adrian M., Redmond, Washington 98052 (US)
(74) Representative: CMS Cameron McKenna Nabarro Olswang LLP

(57) **Abstract**

Trays having pull-out mini-trays with on-board optics modules for use with a rack are described. An example tray includes a pull-out mini-tray with on-board optics modules, including optical transceivers for exchanging signals with electrical connections formed within the pull-out mini-tray, where the pull-out mini-tray is movably engaged with a support structure formed within the tray such that the pull-out mini-tray is movable out of the rack independent of a movement of the entire tray relative to the rack. The tray further includes a set of flexible interconnects formed within the tray to connect the electrical connections to tray connectors formed toward a backend of the tray, allowing for pulling out of at least a portion of the pull-out mini-tray from the frontend of the tray, while still maintaining a connection between the electrical connections formed within the pull-out mini-tray and the tray connectors.

## Description

### BACKGROUND

Hardware clusters for housing Al accelerators require massive scale-up backend networks, which are currently being implemented using copper wires and connectors. In some racks, such as racks for Al accelerators or switches, front-plate-pluggable transceivers may be used. Typically, such pluggable transceiver modules receive electrical signals through the front plate of the rack and convert the electrical signal into optical signals. Fiber cables within the datacenter are then used to transfer the optical signals to other parts of the datacenter. Such front-plate pluggable transceiver modules, however, are not viable for use with the scale-up backend network due to several drawbacks associated with the pluggable transceiver modules, including insufficient bandwidth density, poor energy efficiency, and high cost of deployment.

Accordingly, there is a need for improvements to methods and systems for interconnecting Al accelerators and other components in hardware clusters.

### SUMMARY

In one example, the present disclosure relates to a tray configured to provide a compute functionality, a networking functionality, or a storage functionality, where the tray is movably engaged with a rack, allowing for pulling out at least a portion of the tray out of the rack. The tray may comprise a pull-out mini-tray with on-board optical modules, including optical transceivers for exchanging signals with electrical connections formed within the pull-out mini-tray. The pull-out mini-tray is movably engaged with a support structure formed within the tray such that the pull-out mini-tray is movable out of the rack independent of a movement of the tray relative to the rack.

The tray may further comprise a plurality of integrated circuit (IC) chips, arranged within the tray, where each of the plurality of IC chips is coupled with the electrical connections formed within the pull-out mini-tray. The tray may further comprise a set of flexible interconnects formed within the tray to connect the electrical connections, formed within the pull-out mini-tray, to tray connectors formed toward a first end of the tray. A length of each of the set of flexible interconnects formed within the tray may be selected to allow for pulling out of at least a portion of the pull-out mini-tray from a second end, opposite to the first end, of the tray, while still maintaining a connection between the electrical connections formed within the pull-out mini-tray and the tray connectors formed towards the first end of the tray to allow for an in-field service or an inspection of the on-board optical modules without having to pull out any portion of the tray out of the rack.

In another example, the present disclosure relates to a method for use with a rack including a tray configured to provide a compute functionality, a networking functionality, or a storage functionality, where the tray is movably engaged with a rack. The method may comprise providing a pull-out mini-tray with on-board optical modules, including optical transceivers for exchanging signals with electrical connections formed within the pull-out mini-tray, where the pull-out mini-tray is movably engaged with a support structure formed within the tray such that the pull-out mini-tray is movable out of the rack independent of a movement of the tray relative to the rack.

The method may further comprise providing a plurality of integrated circuit chips (ICs) within the tray, where each of the plurality of IC chips is coupled with the electrical connections formed within the pull-out mini-tray. The method may further comprise connecting, using a set of flexible interconnects formed within the tray, the electrical connections formed within the pull-out mini-tray to tray connectors formed toward a first end of the tray, where a length of each of the set of flexible interconnects formed within the tray is selected to allow for pulling out of at least a portion of the pull-out mini-tray from a second end, opposite to the first end, of the rack while still maintaining a connection between the electrical connections formed within the pull-out mini-tray and the tray connectors formed towards the first end of the tray to allow for in-field service or inspection of the on-board optical modules without having to pull out any portion of the tray out of the rack.

In yet another example, the present disclosure relates to a tray configured to provide a compute functionality, a networking functionality, or a storage functionality, where the tray is movably engaged with a rack, allowing for pulling out at least a portion of the tray out of the rack. The tray may further comprise a pull-out mini-tray with on-board optical modules, including optical transceivers for exchanging signals with electrical connections formed within the pull-out mini-tray, where the pull-out mini-tray is slidably engaged with a pair of rails formed within the tray such that the pull-out mini-tray is slidable out of the rack independent of a movement of the tray relative to the rack.

The tray may further comprise a plurality of integrated circuit (IC) chips, arranged within the tray, where each of the plurality of IC chips is coupled with the electrical connections formed within the pull-out mini-tray. The tray may further comprise a set of flexible interconnects formed within the tray to connect the electrical connections, formed within the pull-out mini-tray, to tray connectors formed toward a backend of the tray, where a length of each of the set of flexible interconnects formed within the tray and the pair of rails formed within the tray is selected to allow for pulling out of at least a portion of the pull-out mini-tray from a frontend of the tray, while still maintaining a connection between the electrical connections formed within the pull-out mini-tray and the tray connectors formed towards the backend of the tray to allow for an in-field service or an inspection of the on-board optical modules without having to pull out any portion of the tray out of the rack.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

### BRIEF DESCRIPTION OF THE DRAWINGS

The present disclosure is illustrated by way of example and is not limited by the accompanying figures, in which like references indicate similar elements. Elements in the figures are illustrated for simplicity and clarity and have not necessarily been drawn to scale.
FIG. 1 is a top view of a compute tray including a pull-out mini-tray with on-board optical modules in accordance with one example;
FIG. 2 is a top view of the pull-out mini-tray with on-board optical modules in accordance with one example;
FIG. 3 is a side view of the pull-out mini-tray with on-board optical modules with the mini-tray within the compute tray in accordance with one example;
FIG. 4 is another side view of the pull-out mini-tray with on-board optical modules with the mini-tray pulled out of the compute tray;
FIG. 5 is a side view of a pull-out mini-tray with on-board optical modules arranged in a double-decker fashion with the mini-tray within the compute tray in accordance with one example;
FIG. 6 is another side view of the pull-out mini-tray with on-board optical modules arranged in a double-decker fashion with the mini-tray pulled out of the compute tray;
FIG. 7 is a top view of a networking tray including a pull-out mini-tray with on-board optical modules in accordance with one example;
FIG. 8 shows an example rack system with multiple racks, each of which can have a number of compute trays, networking trays, or storage trays;
FIG. 9 shows perspective views of trays to further illustrate the arrangement of various components associated with these trays in accordance with one example;
FIG. 10 shows a block diagram of an example scale-up network in a datacenter including nodes implemented using the example rack of FIG. 8 with the trays described herein; and
FIG. 11 is a flowchart of a method for providing a pull-out mini-tray with on-board optical modules in accordance with one example.

### DETAILED DESCRIPTION

Examples described in this disclosure relate to compute and/or networking trays having pull-out mini-trays with on-board optical modules. As noted earlier, hardware clusters for housing Al accelerators require massive scale-up backend networks, which are often implemented using copper wires and connectors. In some racks, such as racks for Al accelerators front-plate-pluggable transceivers may be used. Typically, such pluggable transceiver modules receive electrical signals through the front plate and convert the electrical signal into optical signals. Fiber cables within the datacenter are used to transfer the converted optical signals to other parts of the datacenter. Such front-plate pluggable transceiver modules, however, are not viable for use with the scale-up backend network due to several drawbacks associated with the pluggable transceiver modules, including insufficient bandwidth density, poor energy efficiency, and high cost of deployment.

In-tray optic modules offer some improvements relative to the pluggable transceiver modules; however, they also pose other challenges, including issues with in-place serviceability, resulting in a high blast radius, long downtime and having to replace the whole compute tray in case of problems with the in-tray optics. While front-plate pluggable transceiver modules are in-place serviceable, in-tray optics pose a new challenge, requiring one to fully disconnect the compute tray and then pull out the entire compute tray before servicing the in-tray optics, resulting in a high blast radius, longer downtimes, and more expensive and complex field-replaceable units. Examples described herein relate to compute and/or networking trays having pull-out mini-trays with on-board optical modules, allowing one to service the optical modules in-place without a need to pull out and replace the whole compute tray. On-board optical modules can be assembled on the mini-tray and form a much smaller field-replaceable-unit than a whole compute, storage, or networking tray. In case of an optical failure, a technician can open the protective flap and pull-out the mini-tray for inspection and replacement as needed. During this process, the tray providing the compute, networking, or storage functionality can stay in place, fully connected and powered on.

Trays with on-board optical modules provide several advantages with respect to the processing of generative artificial-intelligence (AI) models, including large language models (LLMs). Generative Al models require multiple racks for training and other uses. In other words, they do not fit in one rack. To allow for the model training or execution across racks, the racks need to be interconnected with each other using high-bandwidth and low-latency links. Using copper wires to interconnect such racks is expensive and impractical since the use of copper wires may require re-timers and re-drivers every twenty to thirty inches along the length of the wires. The use of on-board optical modules to form optical links for interconnecting the racks removes the need for any re-timers, thereby eliminating the need for such re-timers and re-drivers. This results in lower costs and more efficient implementation of multi-rack deployment of generative Al models, including LLMs. In addition, the removal of re-timers and re-drivers lowers the power consumption since the excess power consumption by such components is eliminated.

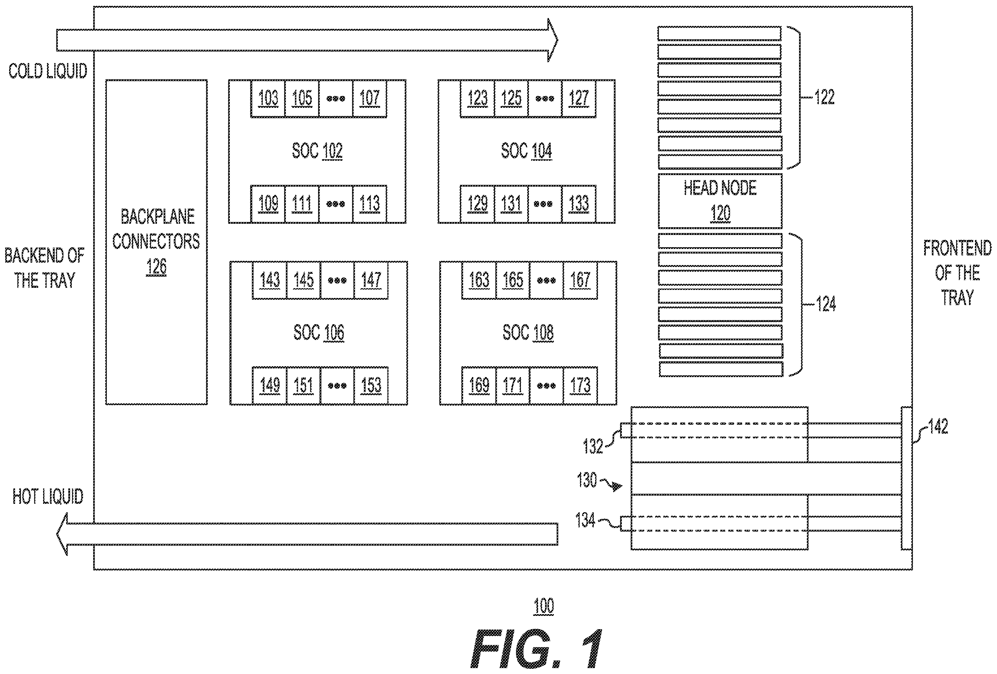

FIG. 1 is a top view of a compute tray 100 including a pull-out mini-tray 130 with on-board optical modules in accordance with one example. Compute tray 100 can be housed within a rack, or a similar structure, to provide compute functionality within a data center. Compute tray 100 can be arranged in a rack having a frontend and a backend as indicated in FIG. 1. The terms "frontend" and the "backend" are used as relative terms to differentiate one end of the tray from another end of the tray. Cold liquid (or cold air) can be supplied from the backend of the rack towards the frontend of the rack, and hot liquid (or hot air) can be sent back towards the backend of the rack. Compute tray 100 can include multiple components, including power supplies, wires, and integrated circuit (IC) chips mounted on circuit boards. As used herein the term "tray" includes any structures for deploying compute, networking, or storage components," including structures, such as blades, chassis, or other such housing structures. In this example, compute tray 100 includes four systems on chip (SoCs) 102, 104, 106, and 108 mounted on circuit boards within compute tray 100. Circuit boards housed within compute tray 100 may be formed using a fiberglass sheet sandwiched between copper sheets (or similar metal or alloy sheets). Wires may be formed by etching wire patterns and removing copper (or a similar metal) where the wires are not desirable. Holes may be formed to create connections for leads or other wires. Substrates other than fiberglass sheets may also be used.

SoC 102 includes several copper connection blocks 103, 105, 107, 109, 111, and 113, which allow interconnection with other components within compute tray 100 using busses (e.g., PCle or other high-speed busses). Similarly, SoC 104 includes several copper connection blocks 123, 125, 127, 129, 131, and 133, which allow interconnection with other components within compute tray 100 using busses (e.g., PCle or other high-speed busses). SoC 106 also includes several copper connection blocks 143, 145, 147, 149, 151, and 153, which allow interconnection with other components within compute tray 100 using busses (e.g., PCle or other high-speed busses). Finally, SoC 108 also includes several copper connection blocks 163, 165, 167, 169, 171, and 173, which allow interconnection with other components within compute tray 100 using busses (e.g., PCle or other high-speed busses). Aside from SoCs 102, 104, 106, and 108, compute tray 100 may include other compute/control devices, such as graphics processing units (GPUs), Field-Programmable Gate Arrays (FPGAs), Application-Specific Integrated Circuits (ASICs), Application-Specific Standard Products (ASSPs), Complex Programmable Logic Devices (CPLDs), and the like. In addition, although the connection blocks are referred to as copper connection blocks as part of the description of FIG. 1, other suitable metals may also be used.

With continued reference to FIG. 1, compute tray 100 further includes a head node 120 and memory modules 122 and 124. Compute tray 100 further includes backplane connectors 126, which can be copper connection block towards the backend of the tray. As an example, head node 120 may be a central processing unit (CPU). Examples of memory modules 122 and 124 include high-bandwidth memory (HBM modules), dual-in-line memory modules (DIMMs) or single-in-line memory modules (SIMMs). Memory included in the memory modules 122 and 124 may be dynamic random access memory (DRAM), flash memory, static random access memory (SRAM), phase change memory, magnetic random access memory, or any other type of memory technology. Head node 120 may access the memory in memory modules 122 and 124 via memory controllers. The memory controllers associated with the head node 120 may be a double dynamic rate (DDR) DRAM controller in case the memory modules include DDR DRAM. Other appropriate controllers may be used based on the memory included within memory modules 122 and 124.

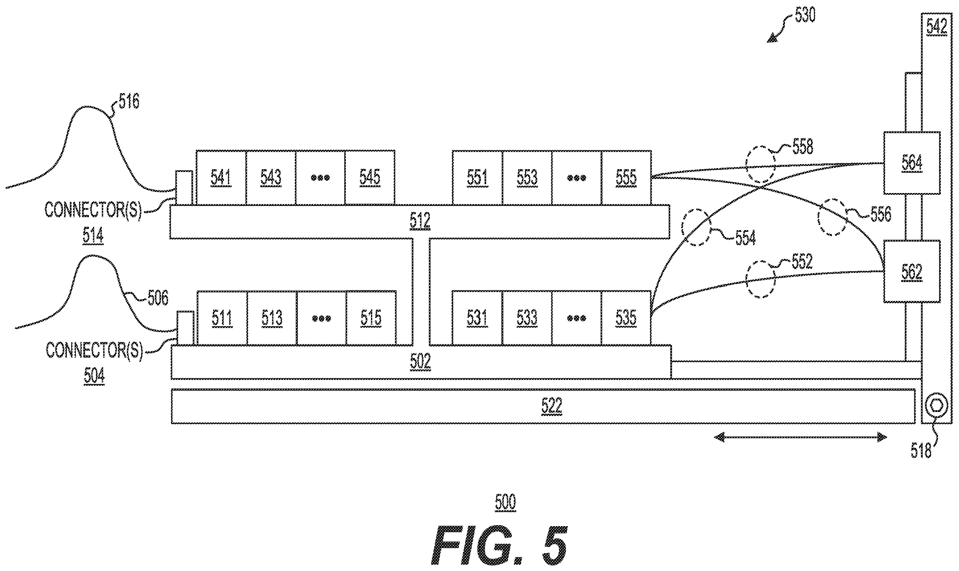

Still referring to FIG. 1, pull-out mini-tray 130 is shown as slidably mounted on a pair of rails 132 and 134. A flappable cover 142 is arranged on the side of compute tray 100, which can be opened and closed, allowing for the pull-out mini-tray 130 to be pulled out of compute tray 100 while being supported by the pair of rails 132 and 134. As shown further in detailed views later, the on-board optical modules formed within the pull-out mini-tray are coupled via flyover flexible interconnects to tray connectors formed within the tray. The length of each of the set of flexible interconnects formed within the tray is selected to allow for pulling out of at least a portion of the pull-out mini-tray while still maintaining a connection between the electrical connections formed within the pull-out mini-tray and the tray connectors formed towards the backend of the tray to allow for in-field service or inspection of the on-board optical modules without having to pull out any portion of the tray out of the rack. As used herein the term "electrical connections" includes metal connections, hybrid metallic polymer connections, elastomeric connections, or any other type of electrical connections. The set of flexible interconnects can be formed using a set of flyover flexible cables or one or more flexible printed circuit boards. Although FIG. 1 shows compute tray 100 as having a certain number of components arranged in a certain manner, compute tray 100 may include additional or fewer components that are arranged differently. As an example, although compute tray 100 is shown as having the pull-out mini-tray 130 arranged in a corner, pull-out mini-tray 130 and the supporting structures (e.g., the pair of rails 132 and 134) can be arranged in other places. As an example, pull-out mini-tray 130 may be arranged in a location where the backplane connectors 126 are shown. Pull-out mini-tray 130 can be arranged on top of the backplane connectors 126 in a mezzanine fashion (e.g., similar to the double-decker arrangement of the pull-out mini-trays shown in FIG. 5). Alternatively, pull-out mini-tray 130, along with the supporting structures, can be placed in the space(s) next to the backplane connectors 126.

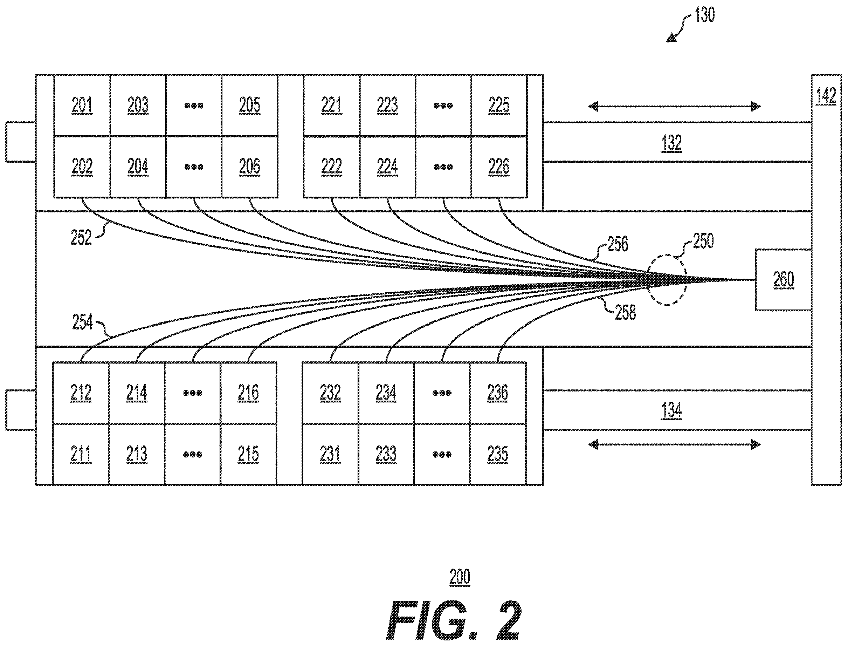

FIG. 2 is a top view 200 of the pull-out mini-tray 130 of FIG. 1 with on-board optical modules in accordance with one example. Top view 200 of the pull-out mini-tray 130 shows additional details of the pull-out mini-tray 130 of FIG. 1. Unless expressly indicated otherwise, the same or similar components and structures that are shown in FIG. 2 are referred to using the same reference numbers as used in FIG. 1. As a result, such same or similar components and structures may not be referred to again as part of the description associated with FIG. 2. Pull-out mini-tray 130 includes on-board optical modules (e.g., optical modules 202, 204, 206, 212, 214, 216, 222, 224, 226, 232, 234, and 236) including optical transceivers for exchanging signals with electrical connections (e.g., electrical connections 201, 203, 205, 211, 213, 215, 221, 223, 225, 231, 233, and 235) formed within the pull-out mini-tray 130. The on-board optical modules (e.g., optical modules 202, 204, 206, 212, 214, 216, 222, 224, 226, 232, 234, and 236) are coupled via a fiber-optics bundle 250 to one or more passive fiber connectors (e.g., passive fiber connector 260), which aggregates the fiber-optic wires (e.g., fiber-optics wires 252, 254, 256 and 258) for communication with optical switches or other equipment outside the tray. The fiber-optics bundle 250 is supported by a holder associated with the pull-out mini-tray 130.

In this example, the pull-out mini-tray 130 is slidably engaged with a support structure (e.g., a pair of rails 132 and 134) formed within the tray (e.g., compute tray 100 of FIG. 1) such that the pull-out mini-tray 130 is movable out of the rack (e.g., a rack housing the compute tray 100 of FIG. 1) independent of a movement of the tray relative to the rack. As described earlier a flappable cover 142 is arranged on the side of the tray (e.g., compute tray 100), which can be opened and closed, allowing for the pull-out mini-tray 130 to be pulled out of the tray while being supported by the pair of rails 132 and 134. As used herein the term "mini-tray" refers to any tray that requires less floor space than the floor space required by the tray housing it. As an example, pull-out mini-tray 130 is smaller in terms of the floor space that it takes up relative to the floor space taken up by compute tray 100 within which pull-out mini-tray 130 is located. Although FIG. 2 shows pull-out mini-tray 130 as having a certain number of components arranged in a certain manner, pull-out mini-tray 130 may include additional or fewer components that are arranged differently.

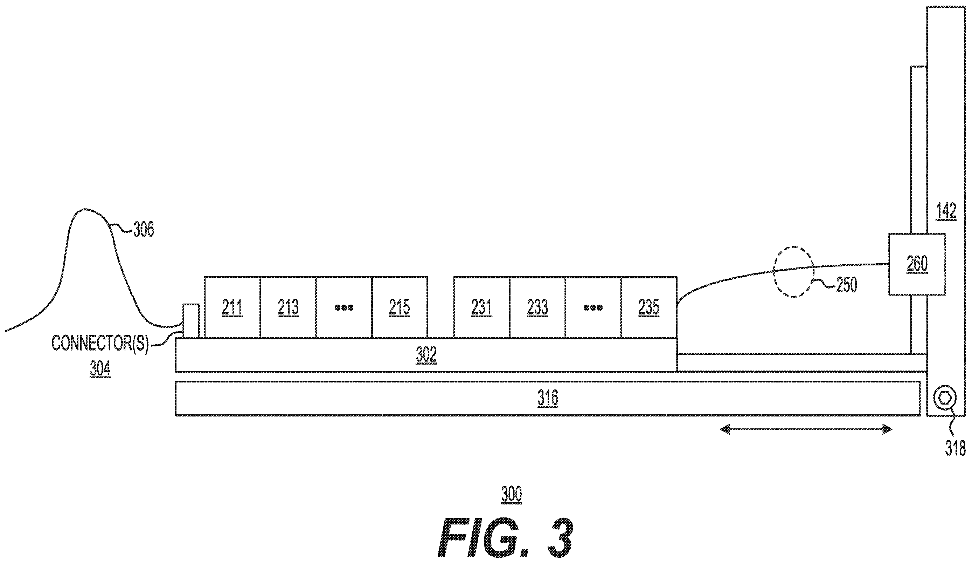

FIG. 3 is a side view 300 of the pull-out mini-tray 200 of FIG. 2 with on-board optical modules with the mini-tray within the compute tray in accordance with one example. Unless expressly indicated otherwise, the same or similar components and structures that are shown in FIG. 3 are referred to using the same reference numbers as used in FIG. 1 and FIG. 2. As a result, such same or similar components and structures may not be referred to again as part of the description associated with FIG. 3. Side view 300 shows substrate 302, which forms the bottom of the pull-out mini-tray. Side view 300 also shows a hinge 318, which allows flappable cover 142 to be swiveled in a manner to allow for one to pull out the pull-out mini-tray for in-field service and/or inspection. Side view 300 further shows a side view of one of the pair of rails 316. Side view 300 further shows a subset of the electrical connections formed within the pull-out mini-tray, including electrical connections 211, 213, 215, 231, 233, and 235 of FIG. 2. Side view 300 further shows a side view of a set of flexible interconnects 306 coupled with the electrical connections (e.g., electrical connections 211, 213, 215, 231, 233, and 235) via connector(s) 304.

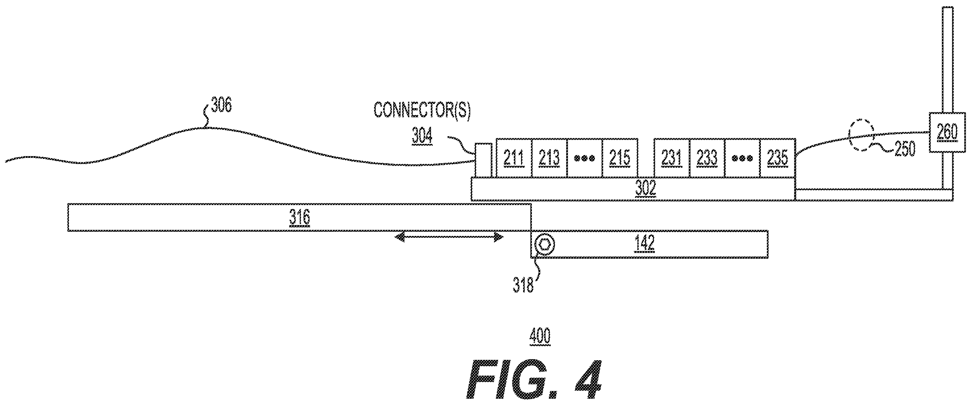

FIG. 4 is another side view 400 of the pull-out mini-tray 200 of FIG. 2 with on-board optical modules with the mini-tray pulled out of the compute tray. Unless expressly indicated otherwise, the same or similar components and structures that are shown in FIG. 4 are referred to using the same reference - numbers as used in FIGs. 1-3. As a result, such same or similar components and structures may not be referred to again as part of the description associated with FIG. 4. Side view 400 shows substrate 302, which forms the bottom of the pull-out mini-tray. Side view 400 further shows a side view of one of the pair of rails 316. Side view 400 shows flappable cover 142 opened, allowing the pull-out mini-tray to be pulled out of the tray. Side view 400 further shows a subset of the electrical connections formed within the pull-out mini-tray, including electrical connections 211, 213, 215, 231, 233, and 235 of FIG. 2. Side view 400 further shows a side view of a set of flexible interconnects 306 coupled with the electrical connections (e.g., electrical connections 211, 213, 215, 231, 233, and 235) via connector(s) 304. The length of each of the set of flexible interconnects 306 is selected such that even when the tray is pulled out the set of flexible interconnects stay connected with connector(s) 304 and tray connectors (not shown in this figure) towards the backend of the tray (e.g., the backend of the compute tray 100 of FIG. 1).

FIG. 5 is a side view 500 of a pull-out mini-tray 530 with on-board optical modules arranged in a double-decker fashion with the mini-tray within the compute tray in accordance with one example. Unless expressly indicated otherwise, the same or similar components and structures that are shown in FIG. 5 have the same or a similar function as described with respect to FIGs. 1-4. Pull-out mini tray 530 is similar to pull-out mini-tray 130 of FIG. 1 in all respects, except this mini-tray includes two on-board optical modules that are arranged in a double-decker fashion. Side view 500 shows substrate 502, which forms the bottom of the lower level of the pull-out mini-tray 530. Side view 500 further shows a side view of one of the pair of rails 522 (similar to the power rails 132 and 134 of FIG. 1). Side view 500 further shows a subset of the electrical connections formed within the pull-out mini-tray, including electrical connections 511, 513, 515, 531, 533, and 535. Side view 500 further shows a side view of a set of flexible interconnects 506 coupled with the electrical connections (e.g., electrical connections 511, 513, 515, 531, 533, and 535) via connector(s) 504.

Side view 500 further shows substrate 512, which forms the bottom of the upper level of the pull-out mini-tray 530. Side view 500 further shows a subset of the electrical connections formed within the upper level of the pull-out mini-tray 530, including electrical connections 541, 543, 545, 551, 553, and 555. Side view 500 further shows a side view of a set of flexible interconnects 516 coupled with the electrical connections (e.g., electrical connections 541, 543, 545, 551, 553, and 555) via connector(s) 514. Also shown in the side view 500 is the flappable cover 542. Side view 500 also shows a hinge 518, which allows flappable cover 542 to be swiveled in a manner to allow for one to pull out the pull-out mini-tray for in-field service and/or inspection. Moreover, side view 500 shows two different sets of passive fiber connectors 562 and 564. The on-board optical modules (not visible in the side view 500) on the lower level of the pull-out mini-tray 530 are coupled via a fiber-optics bundle 552 to a set of passive fiber connectors 562. The on-board optical modules (not visible in the side view 500) on the lower level of the pull-out mini-tray 530 are further coupled via a fiber-optics bundle 554 to a set of passive fiber connectors 564. The on-board optical modules (not visible in the side view 500) on the upper level of the pull-out mini-tray 530 are coupled via a fiber-optics bundle 556 to a passive fiber connector 562. The on-board optical modules (not visible in the side view 500) on the upper level of the pull-out mini-tray 530 are further coupled via a fiber-optics bundle 558 to a passive fiber connector 564.

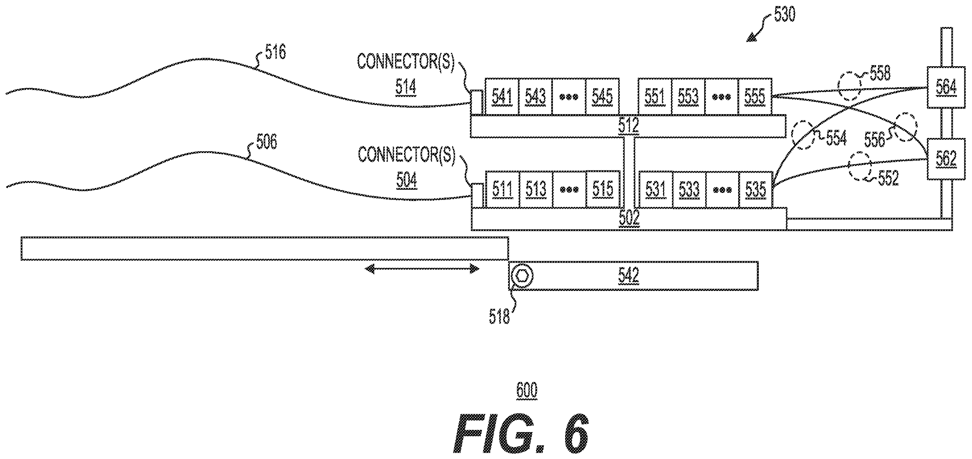

FIG. 6 is another side view 600 of the pull-out mini-tray 530 of FIG. 5 with the on-board optical modules arranged in a double-decker fashion with the mini-tray pulled out of the compute tray. Unless expressly indicated otherwise, the same or similar components and structures that are shown in FIG. 6 are referred to using the same reference numbers as used in FIG. 5. As a result, such same or similar components and structures may not be referred to again as part of the description associated with FIG. 6. Side view 600 shows flappable cover 542 opened, allowing the pull-out mini-tray 530 to be pulled out of the tray. The length of each of the set of flexible interconnects 506 and 516 is selected such that even when the tray is pulled out the set of flexible interconnects stay connected with respective connector(s) 504 and 514 and with tray connectors (not shown in this figure) towards the backend of the tray (e.g., the backend of the compute tray 100 of FIG. 1).

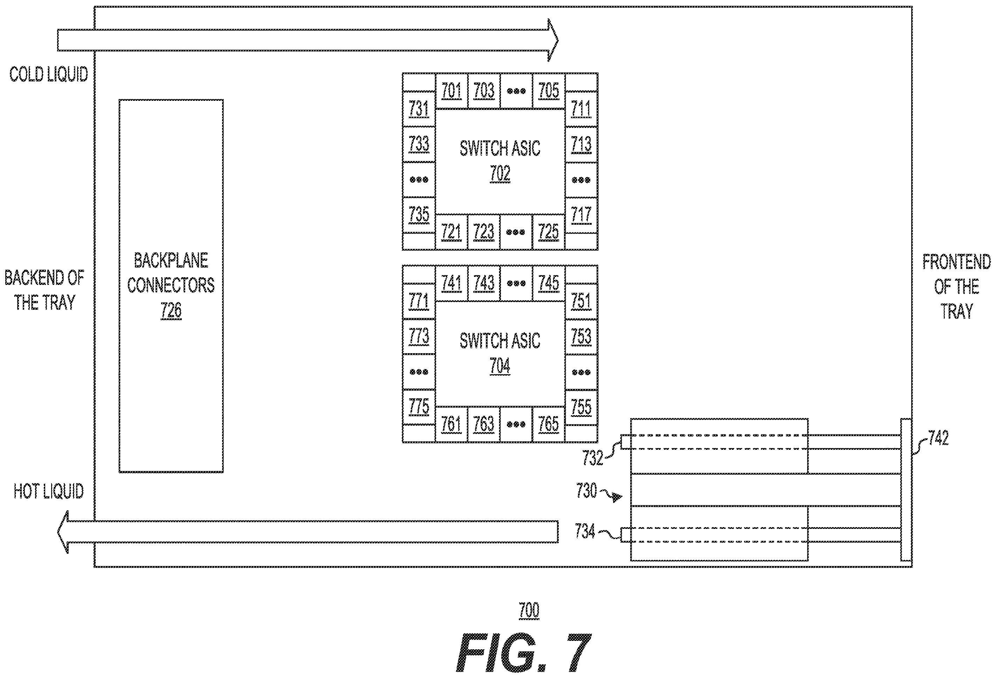

FIG. 7 is a top view of a networking tray 700 including a pull-out mini-tray 730 with on-board optical modules in accordance with one example. Unless expressly indicated otherwise, the same or similar components and structures that are shown in FIG. 7 have the same or a similar function as described with respect to FIGs. 1-6. Networking tray 700 can be used with a rack housed within a rack, or a similar structure, to provide networking and/or switching functionality within a data center. Networking tray 700 can be arranged in a rack having a backend and a frontend as indicated in FIG. 7 (similar to compute tray 100 of FIG. 1, when arranged in a rack). Cold liquid (or cold air) can be supplied from the backend of the rack towards the frontend of the rack, and hot liquid (or hot air) can be sent back towards the backend of the rack. Networking tray 700 can include multiple components, including power supplies, wires, and integrated circuit (IC) chips mounted on circuit boards. In this example, networking tray 700 includes two switch ASICs 702 and 704 mounted on circuit boards within the networking tray 700. Similar to as described earlier with respect to compute tray 100 of FIG. 1, circuit boards housed within networking tray 700 may be formed using a fiberglass sheet sandwiched between copper sheets (or similar metal or alloy sheets). Wires may be formed by etching wire patterns and removing copper (or a similar metal) where the wires are not desirable. Holes may be formed to create connections for leads or other wires. Substrates other than fiberglass sheets may also be used. Networking tray 700 further includes backplane connectors 726, which can be copper connection block towards the backend of the rack.

Switch ASIC 702 includes several copper connection blocks 701, 703, 705, 711, 713, 715, 721, 723, 725, 731, 733, and 735, which allow interconnection with other components within networking tray 700 using busses (e.g., PCle or other high-speed busses). Similarly, switch ASIC 704 includes several copper connection blocks 741, 743, 745, 751, 753, 755, 761, 763, 765, 771, 773, 775, which allow interconnection with other components within networking tray 700 using busses (e.g., PCle or other high-speed busses). Aside from the switch ASICs 702 and 704, networking tray 700 may include other compute/control devices, such as graphics processing units (GPUs), Field-Programmable Gate Arrays (FPGAs), Application-Specific Integrated Circuits (ASICs), Application-Specific Standard Products (ASSPs), Complex Programmable Logic Devices (CPLDs), and the like. In addition, although the connection blocks are referred to as copper connection blocks as part of the description of FIG. 7, other suitable metals may also be used.

Still referring to FIG. 7, pull-out mini-tray 730 is shown as slidably mounted on a pair of rails 732 and 734. Pull-out mini-tray 730 is similar to pull-out mini-tray 130 of FIG. 1 in terms of its functionality and the way it is slidably mounted. A flappable cover 742 (similar to flappable cover 142 of FIG. 1) is arranged on the side of networking tray 700, which can be opened and closed, allowing for the pull-out mini-tray 730 to be pulled out of networking tray 700 while being supported by the pair of rails 732 and 734. As shown further in detailed views later, the on-board optical modules formed within the pull-out mini-tray 730 are coupled via flyover flexible interconnects to tray connectors formed within the tray. The length of each of the set of flexible interconnects formed within the tray is selected to allow for pulling out of at least a portion of the pull-out mini-tray while still maintaining a connection between the electrical connections formed within the pull-out mini-tray and the tray connectors formed towards the backend of the tray to allow for in-field service or inspection of the on-board optical modules without having to pull out any portion of the tray out of the rack. The set of flexible interconnects can be formed using a set of flyover flexible cables or one or more flexible printed circuit boards. Although FIG. 7 shows networking tray 700 as having a certain number of components arranged in a certain manner, networking tray 700 may include additional or fewer components that are arranged differently.

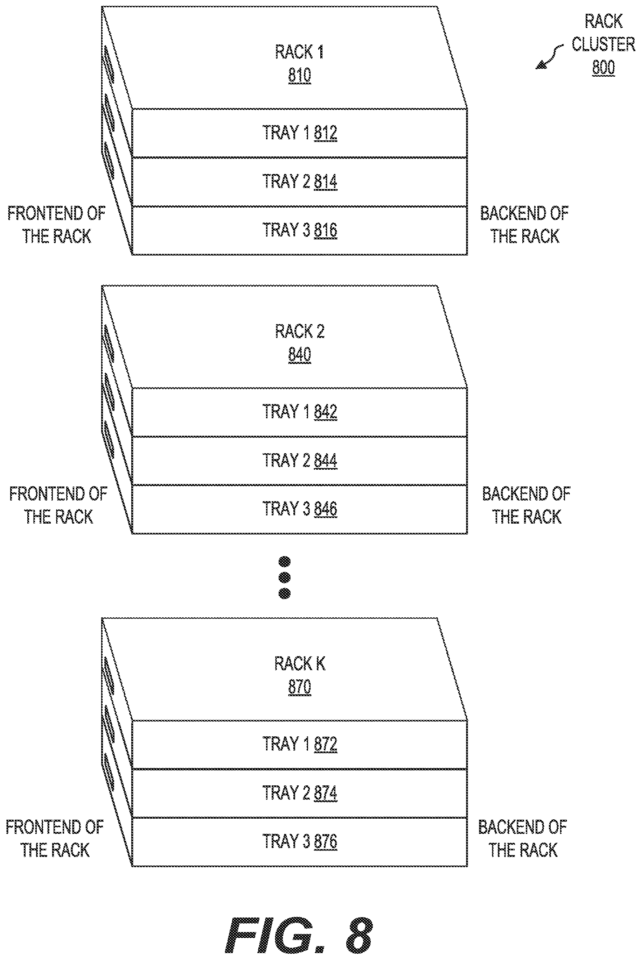

FIG. 8 shows an example rack system 800 with multiple racks each of which can have a number of compute trays, networking trays, or storage trays. Rack system 800 is shown as having K number of racks, where K is at least 4. As an example, rack system 800 is shown with rack 1 810, rack 2 840, and rack K 870. Rack 1 810 is shown with tray 1 812, tray 2 814, and tray 3 816. Each one of these trays can be any one of compute tray 100 of FIG. 1, networking tray 700 of FIG. 7, or a storage tray with storage-related integrated circuit chips. Rack 2 840 is shown with tray 1 842, tray 2 844, and tray 3 846. Each one of these trays can be any one of compute tray 100 of FIG. 1, networking tray 700 of FIG. 7, or a storage tray with storage-related integrated circuit chips. Rack K 870 is shown with tray 1 872, tray 2 874, and tray 3 876. Each one of these trays can be any one of compute tray 100 of FIG. 1, networking tray 700 of FIG. 7, or a storage tray with storage-related integrated circuit chips. As explained earlier, pull-out mini-trays arranged within these trays can be pulled out from one end of the rack (e.g., the frontend of the rack or the backend of the rack) for in-field service and/or inspection without having to pull out the trays (e.g., any of the trays shown in FIG. 8) out of the rack. Although FIG. 8 shows rack system 800 as having a certain number of components arranged in a certain manner, rack system 800 may include additional or fewer components that are arranged differently.

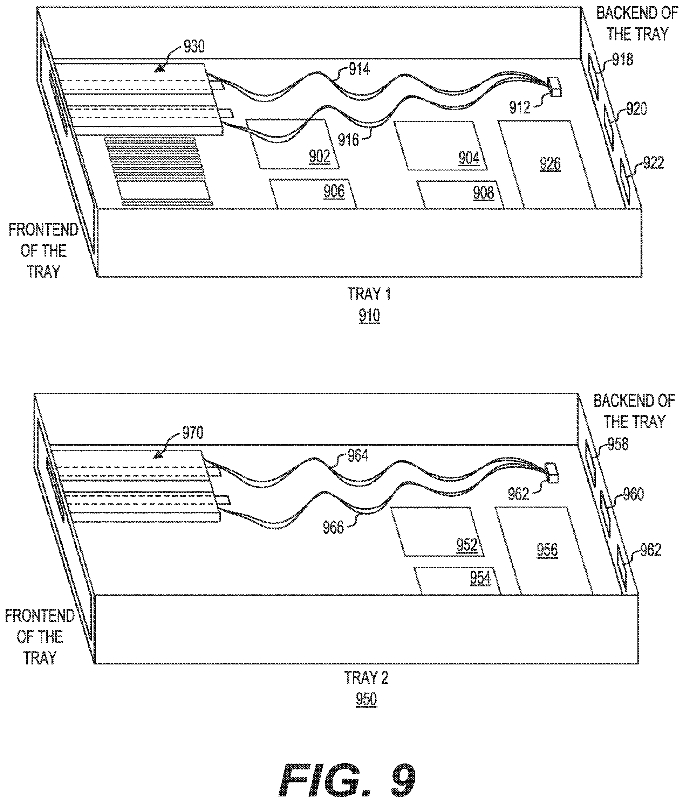

FIG. 9 shows perspective views of a tray 1 910 and a tray 2 950 to further illustrate the arrangement of various components associated with these trays in accordance with one example. Tray 910 can be arranged in a rack having a frontend and a backend, such as the rack shown as part of rack 800 of FIG. 8. Tray 910 can include multiple components, including power supplies, wires, and integrated circuit (IC) chips mounted on circuit boards. In this example, tray 910 includes four integrated circuit (IC) chips 902, 904, 906, and 908 mounted on circuit boards within the tray 910. Each of these integrated circuit chips can include electrical connectors, which allow interconnection with other components within tray 910 using busses (e.g., PCle or other high-speed busses). Aside from the IC chips 902, 904, 906, and 908, tray 910 may include other compute/control devices, such as graphics processing units (GPUs), Field-Programmable Gate Arrays (FPGAs), Application-Specific Integrated Circuits (ASICs), Application-Specific Standard Products (ASSPs), Complex Programmable Logic Devices (CPLDs), and the like. Tray 910 further includes backplane connectors 926.

With continued reference to FIG. 9, tray 910 includes a pull-out mini-tray 930, which is supported by a support structure (e.g., similar to a pair of rails 132 and 134 of FIG. 1) within tray 910. On-board optical modules formed within the pull-out mini-tray 930 are coupled via flyover flexible interconnects 914 and 916 to tray connector(s) 912 formed within the tray. The length of each of the set of flexible interconnects 914 and 916 formed within tray 910 is selected to allow for pulling out of at least a portion of the pull-out mini-tray 930 while still maintaining a connection between the electrical connections formed within the pull-out mini-tray 930 and the tray connector(s) 912 formed towards the backend of the tray to allow for an in-field service or inspection of the on-board optical modules without having to pull out any portion of the tray 910 out of the rack. As noted earlier, the set of flexible interconnects can be formed using a set of flyover flexible cables or one or more flexible printed circuit boards. Tray 910 is also shown with connectors 918, 920, and 922, which are located towards the backend of the rack. These connectors can be used to couple tray 910 to receive power, transmit/receive signals to/from other trays or rack, and exchange signals with the rack controller (not shown).

Still referring to FIG. 9, a perspective view of another tray 950, which can also be arranged in a rack having a frontend and a backend, such as the rack shown as part of rack 800 of FIG. 8, is shown. Tray 950 can include multiple components, including power supplies, wires, and integrated circuit (IC) chips mounted on circuit boards. In this example, tray 950 includes two integrated circuit (IC) chips 952 and 954 mounted on circuit boards within the tray 950. Each of these integrated circuit chips can include electrical connectors, which allow interconnection with other components within tray 950 using busses (e.g., PCle or other high-speed busses). Aside from the IC chips 952 and 954, tray 950 may include other compute/control devices, such as graphics processing units (GPUs), Field-Programmable Gate Arrays (FPGAs), Application-Specific Integrated Circuits (ASICs), Application-Specific Standard Products (ASSPs), Complex Programmable Logic Devices (CPLDs), and the like. Tray 950 further includes backplane connectors 956.

With continued reference to FIG. 9, tray 950 includes a pull-out mini-tray 970, which is supported by a support structure (e.g., similar to a pair of rails 132 and 134 of FIG. 1) within tray 950. On-board optical modules formed within the pull-out mini-tray 970 are coupled via flyover flexible interconnects 964 and 966 to tray connector(s) 962 formed within the tray. The length of each of the set of flexible interconnects 964 and 966 formed within the tray 960 is selected to allow for pulling out of at least a portion of the pull-out mini-tray 970 while still maintaining a connection between the electrical connections formed within the pull-out mini-tray 970 and the tray connector(s) 962 formed towards the backend of the tray to allow for an in-field service or inspection of the on-board optical modules without having to pull out any portion of the tray 950 out of the rack. As noted earlier, the set of flexible interconnects can be formed using a set of flyover flexible cables or one or more flexible printed circuit boards. Tray 950 is also shown with connectors 958, 960, and 962, which are located towards the backend of the rack. These connectors can be used to couple tray 950 to receive power, transmit/receive signals to/from other trays or rack, and exchange signals with the rack controller (not shown). Although FIG. 9 shows trays 910 and 950 as having a certain number of components arranged in a certain manner, trays 910 and 950 may include additional or fewer components that are arranged differently. As before, the terms "frontend" and the "backend" are used as relative terms to differentiate one end of the rack from another end of the rack.

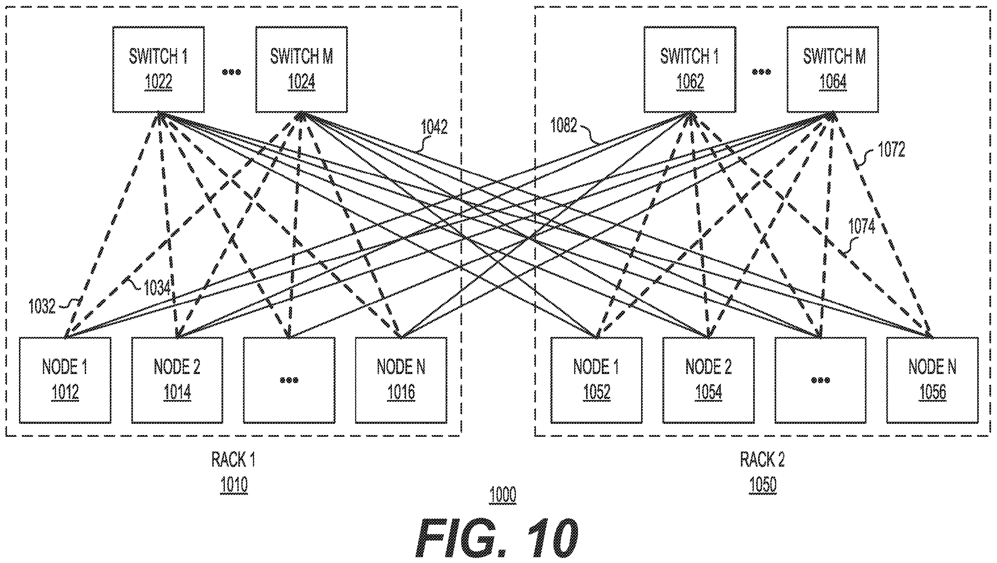

FIG. 10 shows a block diagram of an example scale-up network 1000 in a datacenter including nodes implemented using the example rack 800 of FIG. 8 with a rack having trays described herein. As used in this disclosure, the term data center may include, but is not limited to, some or all of the data centers owned by a cloud service provider, some or all of the data centers owned and operated by a cloud service provider, some or all of the data centers owned by a cloud service provider that are operated by a customer of the service provider, any other combination of the data centers, a single data center, or even some clusters in a particular data center. In one example, each cluster may include several identical servers. Thus, a cluster may include servers having a certain amount of compute and a certain amount of memory. Scale-up network 1000 includes racks 1010 and 1050. Rack 1010 includes node 1 1012, node 2 1014, and node N 1016, which are coupled to each other via switch 1 1022 and switch M 1024. Rack 1050 includes node 1 1052, node 2 1054, and node N 1056, which are coupled to each other via switch 1 1062 and switch M 1064. Each of the nodes can be implemented using one or more of the trays described herein. Moreover, each of the switches can also be implemented using the networking trays described herein. Within each rack, the nodes are coupled to each other via copper connections, which are shown as dotted lines. Similarly, within each rack, the switches are coupled to the nodes via copper connections. As an example, in rack 1, node 1 1012 is coupled to switch 1 1022 via copper connection 1032 and is also coupled to switch M 1024 via copper connection 1034. Similarly, in rack 2, node N 1056 is coupled to switch 1 1062 via copper connection 1074 and is also coupled to switch M 1064 via copper connection 1072.

However, across racks, the nodes and switches are coupled via fiber-optic connections (e.g., including fiber-optic connections 1042 and 1082). As explained earlier, having such an arrangement improves the performance of generative Al models and LLMs. The use of pull-out mini-trays improves the serviceability of such racks, allowing for better implementation. Although FIG. 10 shows scale-up network 1000 as having a certain number of nodes and switches arranged in a certain manner, scale-up network 1000 may include additional or fewer nodes and switches, arranged differently.

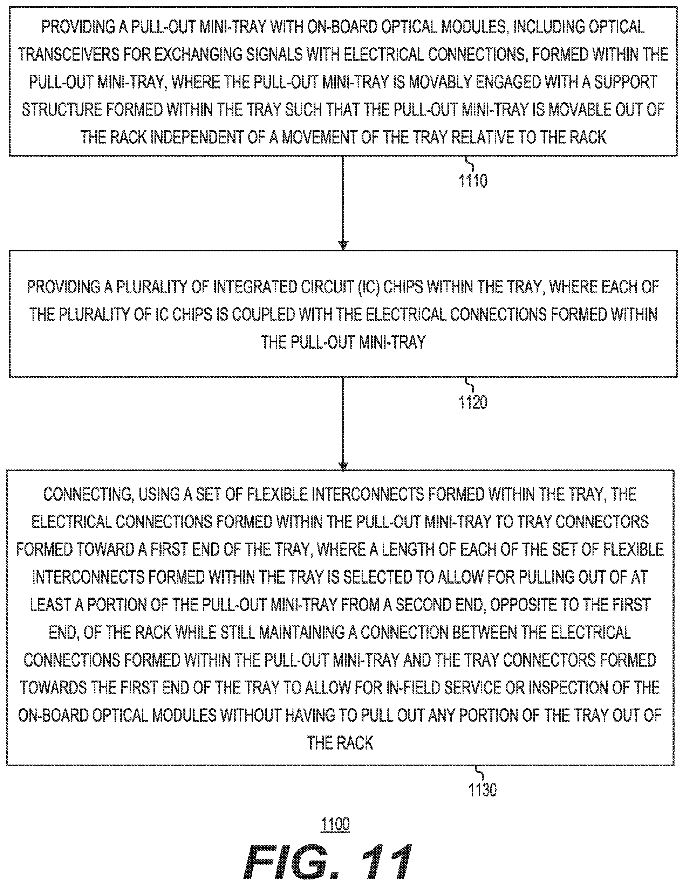

FIG. 11 is a flowchart 1100 of a method for providing a pull-out mini-tray with on-board optical modules in accordance with one example. As an example, the steps associated with the method shown in FIG. 11 can be performed within a datacenter in the context of the use of the pull-out mini-trays described herein. Step 1110 includes providing a pull-out mini-tray with on-board optical modules, including optical transceivers for exchanging signals with electrical connections, formed within the pull-out mini-tray, where the pull-out mini-tray is movably engaged with a support structure formed within the tray such that the pull-out mini-tray is movable out of the rack independent of a movement of the tray relative to the rack. Several examples of pull-out mini-trays and their use in the context of larger trays arranged within a rack are described with respect to FIGs. 1-10. As an example, FIGs. 1 and 7 show different trays with pull-out mini-trays 130 and 730, respectively, which can be provided as part of this step.

Step 1120 includes providing a plurality of integrated circuit chips (ICs) within the tray, where each of the plurality of IC chips is coupled with the electrical connections formed within the pull-out mini-tray. Several examples of IC chips, and their provision as part of larger trays arranged within a rack are described with respect to FIGs. 1-10. As an example, FIGs. 1, 7, and 9 show different trays with IC chips, respectively, which can be provided as part of this step.

Step 1130 includes connecting, using a set of flexible interconnects formed within the tray, the electrical connections formed within the pull-out mini-tray to tray connectors formed toward a first end of the tray, where a length of each of the set of flexible interconnects formed within the tray is selected to allow for pulling out of at least a portion of the pull-out mini-tray from a second end, opposite to the first end, of the rack while still maintaining a connection between the electrical connections formed within the pull-out mini-tray and the tray connectors formed towards the first end of the tray to allow for in-field service or inspection of the on-board optical modules without having to pull out any portion of the tray out of the rack. Several examples of sets of flexible interconnects and their use in the context of pull-out mini-trays located within larger trays, which are further arranged within a rack, are described with respect to FIGs. 1-10. As an example, FIGs. 3-6 and 9 show different sets of flexible interconnects, which can be used to connect electrical connections formed within the pull-out mini-tray to tray connectors formed toward a backend of the tray. As explained earlier, a length of each of the set of flexible interconnects formed within the tray can be selected to allow for the pulling out of at least a portion of the pull-out mini-tray from the frontend of the rack while still maintaining a connection between the electrical connections formed within the pull-out mini-tray and the tray connectors formed towards the backend of the tray. Advantageously, this allows for an in-field service or inspection of the on-board optical modules without having to pull out any portion of the tray out of the rack.

In certain examples, the compute and networking trays described herein are configurable as part of multi-tenant computing systems. The multi-tenant computing system may be a public cloud, a private cloud, or a hybrid cloud. The public cloud includes a global network of servers that perform a variety of functions, including storing and managing data, running applications, and delivering content or services, such as streaming videos, electronic mail, office productivity software, or social media. The servers and other components may be located in data centers across the world. While the public cloud offers services to the public over the Internet, businesses may use private clouds or hybrid clouds. Both private and hybrid clouds also include a network of servers housed in data centers.

In conclusion, the present disclosure relates to a tray configured to provide a compute functionality, a networking functionality, or a storage functionality, where the tray is movably engaged with a rack, allowing for pulling out at least a portion of the tray out of the rack. The tray may comprise a pull-out mini-tray with on-board optical modules, including optical transceivers for exchanging signals with electrical connections formed within the pull-out mini-tray. The pull-out mini-tray is movably engaged with a support structure formed within the tray such that the pull-out mini-tray is movable out of the rack independent of a movement of the tray relative to the rack.

The tray may further comprise a plurality of integrated circuit (IC) chips, arranged within the tray, where each of the plurality of IC chips is coupled with the electrical connections formed within the pull-out mini-tray. The tray may further comprise a set of flexible interconnects formed within the tray to connect the electrical connections, formed within the pull-out mini-tray, to tray connectors formed toward a first end of the tray. A length of each of the set of flexible interconnects formed within the tray may be selected to allow for pulling out of at least a portion of the pull-out mini-tray from a second end, opposite to the first end, of the tray, while still maintaining a connection between the electrical connections formed within the pull-out mini-tray and the tray connectors formed towards the first end of the tray to allow for an in-field service or an inspection of the on-board optical modules without having to pull out any portion of the tray out of the rack.

The support structure is formed within the tray such that the pull-out mini-tray is movable independent of movement of the tray relative to the rack, and wherein the support structure may comprise a pair of rails formed within the tray. A length of the pair of rails along a same plane comprising the set of flexible interconnects formed within the tray may be selected to allow for the pulling out of the at least the portion of the pull-out mini-tray while still maintaining the connection between the electrical connections formed as part of the on-board optical modules and the tray connectors formed towards the first end of the tray to allow for the in-field service or the inspection of the on-board optical modules without having to pull out any portion of the tray out of the rack.

The tray may further comprise a protective flap covering the backend of the tray, where the protective flap is configured to allow for pulling out of the at least the portion of the pull-out mini-tray. The set of flexible interconnects may comprise a set of flyover flexible cables. The set of flexible interconnects may comprise a flexible printed circuit board having connections formed thereon. The on-board optical modules may be arranged in a double-decker fashion within the pull-out mini-tray.

In another example, the present disclosure relates to a method for use with a rack including a tray configured to provide a compute functionality, a networking functionality, or a storage functionality, where the tray is movably engaged with a rack. The method may comprise providing a pull-out mini-tray with on-board optical modules, including optical transceivers for exchanging signals with electrical connections formed within the pull-out mini-tray, where the pull-out mini-tray is movably engaged with a support structure formed within the tray such that the pull-out mini-tray is movable out of the rack independent of a movement of the tray relative to the rack.

The method may further comprise providing a plurality of integrated circuit chips (ICs) within the tray, where each of the plurality of IC chips is coupled with the electrical connections formed within the pull-out mini-tray. The method may further comprise connecting, using a set of flexible interconnects formed within the tray, the electrical connections formed within the pull-out mini-tray to tray connectors formed toward a first end of the tray, where a length of each of the set of flexible interconnects formed within the tray is selected to allow for pulling out of at least a portion of the pull-out mini-tray from a second end, opposite to the first end, of the rack while still maintaining a connection between the electrical connections formed within the pull-out mini-tray and the tray connectors formed towards the first end of the tray to allow for in-field service or inspection of the on-board optical modules without having to pull out any portion of the tray out of the rack.

The support structure is formed within the tray such that the pull-out mini-tray is movable independent of movement of the tray relative to the rack, and where the support structure may comprise a pair of rails formed within the tray. The method may further include selecting a length of the pair of rails along a same plane comprising the set of flexible interconnects formed within the tray to allow for the pulling out of the at least the portion of the pull-out mini-tray while still maintaining the connection between the electrical connections formed as part of the on-board optical modules and the tray connectors formed towards the first end of the tray to allow for the in-field service or the inspection of the on-board optical modules without having to pull out any portion of the tray out of the rack.

The method may further comprise providing a protective flap covering a backend of the tray, wherein the protective flap is configured to allow for pulling out of the at least the portion of the pull-out mini-tray. The set of flexible interconnects may comprise a set of flyover flexible cables. The set of flexible interconnects may comprise a flexible printed circuit board having connections formed thereon. The method may further comprise arranging the on-board optical modules within the pull-out mini-tray in a double-decker fashion.

In yet another example, the present disclosure relates to a tray configured to provide a compute functionality, a networking functionality, or a storage functionality, where the tray is movably engaged with a rack, allowing for pulling out at least a portion of the tray out of the rack. The tray may further comprise a pull-out mini-tray with on-board optical modules, including optical transceivers for exchanging signals with electrical connections formed within the pull-out mini-tray, where the pull-out mini-tray is slidably engaged with a pair of rails formed within the tray such that the pull-out mini-tray is slidable out of the rack independent of a movement of the tray relative to the rack.

The tray may further comprise a plurality of integrated circuit (IC) chips, arranged within the tray, where each of the plurality of IC chips is coupled with the electrical connections formed within the pull-out mini-tray. The tray may further comprise a set of flexible interconnects formed within the tray to connect the electrical connections, formed within the pull-out mini-tray, to tray connectors formed toward a backend of the tray, where a length of each of the set of flexible interconnects formed within the tray and the pair of rails formed within the tray is selected to allow for pulling out of at least a portion of the pull-out mini-tray from a frontend of the tray, while still maintaining a connection between the electrical connections formed within the pull-out mini-tray and the tray connectors formed towards the backend of the tray to allow for an in-field service or an inspection of the on-board optical modules without having to pull out any portion of the tray out of the rack.

The tray may further comprise a protective flap covering the backend of the tray, where the protective flap is configured to allow for pulling out of the at least the portion of the pull-out mini-tray. The set of flexible interconnects may comprise a set of flyover flexible cables. The set of flexible interconnects may comprise a flexible printed circuit board having connections formed thereon.

The on-board optical modules may be arranged in a double-decker fashion within the pull-out mini-tray. The rack may be configured as one of a plurality of nodes of a scale-up backend network within a datacenter, where each of the plurality of IC chips comprises an artificial intelligence (AI)-hardware-accelerator, and where the on-board optical modules are configured for use with the scale-up backend network to allow for compute across multiple racks using the plurality of nodes.

It is to be understood that the methods, modules, and components depicted herein are merely exemplary. Alternatively, or in addition, the functionality described herein can be performed, at least in part, by one or more hardware logic components. For example, and without limitation, illustrative types of hardware logic components that can be used include Field-Programmable Gate Arrays (FPGAs), Application-Specific Integrated Circuits (ASICs), Application-Specific Standard Products (ASSPs), System-on-a-Chip systems (SOCs), Complex Programmable Logic Devices (CPLDs), etc. In an abstract, but still definite sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or inter-medial components. Likewise, any two components so associated can also be viewed as being "operably connected," or "coupled," to each other to achieve the desired functionality. Merely because a component, which may be an apparatus, a structure, a system, or any other implementation of a functionality, is described herein as being coupled to another component does not mean that the components are necessarily separate components. As an example, a component A described as being coupled to another component B may be a sub-component of the component B, the component B may be a sub-component of the component A, or components A and B may be a combined sub-component of another component C.

The functionality associated with some examples described in this disclosure can also include instructions stored in a non-transitory media. The term "non-transitory media" as used herein refers to any media storing data and/or instructions that cause a machine to operate in a specific manner. Exemplary non-transitory media include non-volatile media and/or volatile media. Non-volatile media include, for example, a hard disk, a solid-state drive, a magnetic disk or tape, an optical disk or tape, a flash memory, an EPROM, NVRAM, PRAM, or other such media, or networked versions of such media. Volatile media include, for example, dynamic memory such as DRAM, SRAM, a cache, or other such media. Non-transitory media is distinct from, but can be used in conjunction with transmission media. Transmission media is used for transferring data and/or instruction to or from a machine. Exemplary transmission media include coaxial cables, fiber-optic cables, copper wires, and wireless media, such as radio waves.

Furthermore, those skilled in the art will recognize that boundaries between the functionality of the above described operations are merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the disclosure provides specific examples, various modifications and changes can be made without departing from the scope of the disclosure as set forth in the claims below. Accordingly, the specification and figures are to be regarded in an illustrative rather than a restrictive sense, and all such modifications are intended to be included within the scope of the present disclosure. Any benefits, advantages, or solutions to problems that are described herein with regard to a specific example are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

Trays having pull-out mini-trays with on-board optics modules for use with a rack are described. An example tray includes a pull-out mini-tray with on-board optics modules, including optical transceivers for exchanging signals with electrical connections formed within the pull-out mini-tray, where the pull-out mini-tray is movably engaged with a support structure formed within the tray such that the pull-out mini-tray is movable out of the rack independent of a movement of the entire tray relative to the rack. The tray further includes a set of flexible interconnects formed within the tray to connect the electrical connections to tray connectors formed toward a backend of the tray, allowing for pulling out of at least a portion of the pull-out mini-tray from the frontend of the tray, while still maintaining a connection between the electrical connections formed within the pull-out mini-tray and the tray connectors.

In an example, there is provided a tray configured to provide a compute functionality, a networking functionality, or a storage functionality, wherein the tray is movably engaged with a rack, allowing for pulling out at least a portion of the tray out of the rack, the tray comprising: a pull-out mini-tray with on-board optical modules, including optical transceivers for exchanging signals with electrical connections formed within the pull-out mini-tray, wherein the pull-out mini-tray is movably engaged with a support structure formed within the tray such that the pull-out mini-tray is movable out of the rack independent of a movement of the tray relative to the rack; a plurality of integrated circuit (IC) chips, arranged within the tray, wherein each of the plurality of IC chips is coupled with the electrical connections formed within the pull-out mini-tray; and a set of flexible interconnects formed within the tray to connect the electrical connections, formed within the pull-out mini-tray, to tray connectors formed toward a first end of the rack, where a length of each of the set of flexible interconnects formed within the tray is selected to allow for pulling out of at least a portion of the pull-out mini-tray from a second end, opposite to the first end, of the tray, while still maintaining a connection between the electrical connections formed within the pull-out mini-tray and the tray connectors formed towards the first end of the tray to allow for an in-field service or an inspection of the on-board optical modules without having to pull out any portion of the tray out of the rack.

In an example, the support structure is formed within the tray such that the pull-out mini-tray is movable independent of movement of the tray relative to the rack, and wherein the support structure comprises a pair of rails formed within the tray.

In an example, a length of the pair of rails along a same plane comprising the set of flexible interconnects formed within the tray is selected to allow for the pulling out of the at least the portion of the pull-out mini-tray while still maintaining the connection between the electrical connections formed as part of the on-board optical modules and the tray connectors formed towards the first end of the rack to allow for the in-field service or the inspection of the on-board optical modules without having to pull out any portion of the tray out of the rack.

In an example, the tray further comprises a protective flap covering the backend of the tray, wherein the protective flap is configured to allow for pulling out of the at least the portion of the pull-out mini-tray.

In an example, the set of flexible interconnects comprises a set of flyover flexible cables.

In an example, the set of flexible interconnects comprises a flexible printed circuit board having connections formed thereon.

In an example, the on-board optical modules are arranged in a double-decker fashion within the pull-out mini-tray.

In an example, there is provided a method for use with a rack including a tray configured to provide a compute functionality, a networking functionality, or a storage functionality, wherein the tray is movably engaged with a rack, the method comprising: providing a pull-out mini-tray with on-board optical modules, including optical transceivers for exchanging signals with electrical connections formed within the pull-out mini-tray, wherein the pull-out mini-tray is movably engaged with a support structure formed within the tray such that the pull-out mini-tray is movable out of the rack independent of a movement of the tray relative to the rack; providing a plurality of integrated circuit chips (ICs) within tray, wherein each of the plurality of IC chips is coupled with the electrical connections formed within the pull-out mini-tray; and connecting, using a set of flexible interconnects formed within the tray, the electrical connections formed within the pull-out mini-tray to tray connectors formed toward a first end of the rack, where a length of each of the set of flexible interconnects formed within the tray is selected to allow for pulling out of at least a portion of the pull-out mini-tray from a second end, opposite to the first end, of the rack while still maintaining a connection between the electrical connections formed within the pull-out mini-tray and the tray connectors formed towards the first end of the tray to allow for in-field service or inspection of the on-board optical modules without having to pull out any portion of the tray out of the rack.

In an example, the support structure is formed within the tray such that the pull-out mini-tray is movable independent of movement of the tray relative to the rack, and wherein the support structure comprises a pair of rails formed within the tray.

In an example, the method further comprises selecting a length of the pair of rails along a same plane comprising the set of flexible interconnects formed within the tray to allow for the pulling out of the at least the portion of the pull-out mini-tray while still maintaining the connection between the electrical connections formed as part of the on-board optical modules and the tray connectors formed towards the first end of the tray to allow for the in-field service or the inspection of the on-board optical modules without having to pull out any portion of the tray out of the rack.

In an example, the method further comprises providing a protective flap covering a backend of the tray, wherein the protective flap is configured to allow for pulling out of the at least the portion of the pull-out mini-tray.

In an example, the set of flexible interconnects comprises a set of flyover flexible cables.

In an example, the set of flexible interconnects comprises a flexible printed circuit board having connections formed thereon.

In an example, the method further comprises arranging the on-board optical modules within the pull-out mini-tray in a double-decker fashion.

In an example, there is provided a tray configured to provide a compute functionality, a networking functionality, or a storage functionality, wherein the tray is movably engaged with a rack, allowing for pulling out at least a portion of the tray out of the rack, the tray comprising: a pull-out mini-tray with on-board optical modules, including optical transceivers for exchanging signals with electrical connections formed within the pull-out mini-tray, wherein the pull-out mini-tray is slidably engaged with a pair of rails formed within the tray such that the pull-out mini-tray is slidable out of the rack independent of a movement of the tray relative to the rack; a plurality of integrated circuit (IC) chips, arranged within the tray, wherein each of the plurality of IC chips is coupled with the electrical connections formed within the pull-out mini-tray; and a set of flexible interconnects formed within the tray to connect the electrical connections, formed within the pull-out mini-tray, to tray connectors formed toward a backend of the tray, where a length of each of the set of flexible interconnects formed within the tray and the pair of rails formed within the tray is selected to allow for pulling out of at least a portion of the pull-out mini-tray from a frontend of the tray, while still maintaining a connection between the electrical connections formed within the pull-out mini-tray and the tray connectors formed towards the backend of the tray to allow for an in-field service or an inspection of the on-board optical modules without having to pull out any portion of the tray out of the rack.

In an example, the tray further comprises a protective flap covering the backend of the tray, wherein the protective flap is configured to allow for pulling out of the at least the portion of the pull-out mini-tray.

In an example, the set of flexible interconnects comprises a set of flyover flexible cables.

In an example, the set of flexible interconnects comprises a flexible printed circuit board having connections formed thereon.

In an example, the on-board optical modules are arranged in a double-decker fashion within the pull-out mini-tray.

In an example, the rack is configured as one of a plurality of nodes of a scale-up backend network within a datacenter, wherein each of the plurality of IC chips comprises an artificial intelligence (Al)-hardware-accelerator, and wherein the on-board optical modules are configured for use with the scale-up backend network to allow for compute across multiple racks using the plurality of nodes.

## Claims

1. A tray (100, 812, 910) configured to provide a compute functionality, a networking functionality, or a storage functionality, wherein the tray (100, 812, 910) is movably engaged with a rack (810), allowing for pulling out at least a portion of the tray (100, 812, 910) out of the rack (810), the tray (100, 812, 910) comprising:
a pull-out mini-tray (130, 930) with on-board optical modules (202, 204, 206, 212, 214, 216, 222, 224, 226, 232, 234, and 236), including optical transceivers for exchanging signals with electrical connections (211, 213, 215, 231, 233, and 235) formed within the pull-out mini-tray (130, 930), wherein the pull-out mini-tray (130, 930) is movably engaged with a support structure (132, 134) formed within the tray (100, 812, 910) such that the pull-out mini-tray (130, 930) is movable out of the rack (810) independent of a movement of the tray (100, 812, 910) relative to the rack (810);
a plurality of integrated circuit (IC) chips (102, 104, 106, and 108), arranged within the tray (100, 812, 910), wherein each of the plurality of IC chips (102, 104, 106, and 108) is coupled with the electrical connections (211, 213, 215, 231, 233, and 235) formed within the pull-out mini-tray (130, 930); and
a set of flexible interconnects (306, 914, 916) formed within the tray (100, 812, 910) to connect the electrical connections (211, 213, 215, 231, 233, and 235), formed within the pull-out mini-tray (130, 930), to tray connectors (912) formed toward a first end of the rack (810), where a length of each of the set of flexible interconnects (306, 914, 916) formed within the tray (100, 812, 910) is selected to allow for pulling out of at least a portion of the pull-out mini-tray (130, 930) from a second end, opposite to the first end, of the tray (100, 812, 910), while still maintaining a connection between the electrical connections (211, 213, 215, 231, 233, and 235) formed within the pull-out mini-tray (130, 930) and the tray connectors (912) formed towards the first end of the tray (100, 812, 910) to allow for an in-field service or an inspection of the on-board optical modules (202, 204, 206, 212, 214, 216, 222, 224, 226, 232, 234, and 236) without having to pull out any portion of the tray (100, 812, 910) out of the rack (810).

2. The tray of claim 1, wherein the support structure is formed within the tray such that the pull-out mini-tray is movable independent of movement of the tray relative to the rack, and wherein the support structure comprises a pair of rails formed within the tray.

3. The tray of claim 2, wherein a length of the pair of rails along a same plane comprising the set of flexible interconnects formed within the tray is selected to allow for the pulling out of the at least the portion of the pull-out mini-tray while still maintaining the connection between the electrical connections formed as part of the on-board optical modules and the tray connectors formed towards the first end of the rack to allow for the in-field service or the inspection of the on-board optical modules without having to pull out any portion of the tray out of the rack.

4. The tray of any preceding claim, wherein the tray further comprises a protective flap covering the backend of the tray, wherein the protective flap is configured to allow for pulling out of the at least the portion of the pull-out mini-tray.

5. The tray of any preceding claim, wherein the set of flexible interconnects comprises a set of flyover flexible cables.

6. The tray of any preceding claim, wherein the set of flexible interconnects comprises a flexible printed circuit board having connections formed thereon.

7. The tray of any preceding claim, wherein the on-board optical modules are arranged in a double-decker fashion within the pull-out mini-tray.

8. A method for use with a rack (810) including a tray (100, 812, 910) configured to provide a compute functionality, a networking functionality, or a storage functionality, wherein the tray (100, 812, 910) is movably engaged with a rack (810), the method comprising:
providing a pull-out mini-tray (130, 930) with on-board optical modules (202, 204, 206, 212, 214, 216, 222, 224, 226, 232, 234, and 236), including optical transceivers for exchanging signals with electrical connections (211, 213, 215, 231, 233, and 235) formed within the pull-out mini-tray (130, 930), wherein the pull-out mini-tray (130, 930) is movably engaged with a support structure formed within the tray (100, 812, 910) such that the pull-out mini-tray (130, 930) is movable out of the rack independent of a movement of the tray (100, 812, 910) relative to the rack (810);
providing a plurality of integrated circuit chips (ICs) (102, 104, 106, and 108) within tray (100, 812, 910), wherein each of the plurality of IC chips (102, 104, 106, and 108) is coupled with the electrical connections formed within the pull-out mini-tray (130, 930); and
connecting, using a set of flexible interconnects (306, 914, 916) formed within the tray (100, 812, 910), the electrical connections (211, 213, 215, 231, 233, and 235) formed within the pull-out mini-tray (130, 930) to tray connectors (912) formed toward a first end of the rack (810), where a length of each of the set of flexible interconnects (306, 914, 916) formed within the tray (100, 812, 910) is selected to allow for pulling out of at least a portion of the pull-out mini-tray (130, 930) from a second end, opposite to the first end, of the rack (810) while still maintaining a connection between the electrical connections (211, 213, 215, 231, 233, and 235) formed within the pull-out mini-tray (130, 930) and the tray connectors (912) formed towards the first end of the tray (100, 812, 910) to allow for in-field service or inspection of the on-board optical modules (202, 204, 206, 212, 214, 216, 222, 224, 226, 232, 234, and 236) without having to pull out any portion of the tray (100, 812, 910) out of the rack (810).

9. The method of claim 8, wherein the support structure is formed within the tray such that the pull-out mini-tray is movable independent of movement of the tray relative to the rack, and wherein the support structure comprises a pair of rails formed within the tray.

10. The method of claim 9, further comprising selecting a length of the pair of rails along a same plane comprising the set of flexible interconnects formed within the tray to allow for the pulling out of the at least the portion of the pull-out mini-tray while still maintaining the connection between the electrical connections formed as part of the on-board optical modules and the tray connectors formed towards the first end of the tray to allow for the in-field service or the inspection of the on-board optical modules without having to pull out any portion of the tray out of the rack.

11. The method of any of claims 8 to 10, further comprising providing a protective flap covering a backend of the tray, wherein the protective flap is configured to allow for pulling out of the at least the portion of the pull-out mini-tray.

12. The method of any of claims 8 to 11, wherein the set of flexible interconnects comprises a set of flyover flexible cables.

13. The method of any of claims 8 to 12, wherein the set of flexible interconnects comprises a flexible printed circuit board having connections formed thereon.

14. The method of any of claims 8 to 13, further comprising arranging the on-board optical modules within the pull-out mini-tray in a double-decker fashion.

15. A tray configured to provide a compute functionality, a networking functionality, or a storage functionality, wherein the tray is movably engaged with a rack, allowing for pulling out at least a portion of the tray out of the rack, the tray comprising:
a pull-out mini-tray with on-board optical modules, including optical transceivers for exchanging signals with electrical connections formed within the pull-out mini-tray, wherein the pull-out mini-tray is slidably engaged with a pair of rails formed within the tray such that the pull-out mini-tray is slidable out of the rack independent of a movement of the tray relative to the rack;
a plurality of integrated circuit (IC) chips, arranged within the tray, wherein each of the plurality of IC chips is coupled with the electrical connections formed within the pull-out mini-tray; and
a set of flexible interconnects formed within the tray to connect the electrical connections, formed within the pull-out mini-tray, to tray connectors formed toward a backend of the tray, where a length of each of the set of flexible interconnects formed within the tray and the pair of rails formed within the tray is selected to allow for pulling out of at least a portion of the pull-out mini-tray from a frontend of the tray, while still maintaining a connection between the electrical connections formed within the pull-out mini-tray and the tray connectors formed towards the backend of the tray to allow for an in-field service or an inspection of the on-board optical modules without having to pull out any portion of the tray out of the rack.
